# DEMANDE DE BREVET EUROPEEN

(11) **EP 4 852 654 A1**
(43) Date de publication de la demande: **09.12.2026**
(21) Numéro de dépôt: 26180911.5
(22) Date de dépôt: 26.05.2026
(51) Int. Cl.: H10D 84/85, H10D 86/00, H10D 30/69, H10D 84/03, H10D 84/01, H10D 84/83, H10D 86/01

(54) **PROCÉDÉ DE FABRICATION D'UN DISPOSITIF ÉLECTRONIQUE**

(30) Priorité: 03.06.2025 FR 2505930
(71) Demandeur: STMicroelectronics International N.V., 1228 Plan-les-Ouates, Geneva (CH)
(72) Inventeur: WEBER, Olivier, 38000 GRENOBLE (FR); ARNAUD, Franck, 38330 SAINT NAZAIRE LES EYMES (FR)
(74) Mandataire: Cabinet Beaumont

(57) **Abrégé**

La présente description concerne un dispositif électronique (10) comprenant, sur un même substrat (18) :
- un premier transistor (12) à canal N, situé dans une première région (A) du substrat (18) ;
- un deuxième transistor (14) à canal P, situé dans une deuxième région (B) du substrat (18) ; et
- un troisième transistor (16) à canal P, situé dans une troisième région (C) du substrat (18),
des régions (40, 42) de source et de drain des premier et deuxième transistors (12, 14) sont en silicium épitaxié, et des régions (48, 50) de source et de drain du troisième transistor (16) sont en SiGe épitaxié.

## Description

### Domaine technique

La présente description concerne de façon générale les dispositifs électroniques et leurs procédés de fabrication, et plus particulièrement les dispositifs électroniques comprenant une cointégration de transistors de différents types et leurs procédés de fabrication.

### Technique antérieure

Les dispositifs comprennent généralement différents composants électroniques. Les procédés de fabrication de dispositifs doivent ainsi permettre la fabrication, simultanée ou séquentiellement, de ces différents composants. Cependant, la fabrication du dispositif peut faire face à des problèmes, comme par exemple les budgets de températures incompatibles et l'augmentation du nombre de masques nécessaires.

### Résumé de l'invention

Un mode de réalisation prévoit un dispositif électronique comprenant, sur un même substrat : - un premier transistor à canal N, situé dans une première région du substrat ; - un deuxième transistor à canal **P,** situé dans une deuxième région du substrat ; et - un troisième transistor à canal **P,** situé dans une troisième région du substrat, des régions de source et de drain des premier et deuxième transistors sont en silicium épitaxié, et des régions de source et de drain du troisième transistor sont en SiGe épitaxié.

Un autre mode de réalisation prévoit un procédé de formation d'un dispositif électronique comprenant, sur un même substrat : a) la formation d'un premier transistor à canal N, situé dans une première région du substrat ; b) la formation d'un deuxième transistor à canal P, situé dans une deuxième région du substrat ; et c) la formation d'un troisième transistor à canal P, situé dans une troisième région du substrat, les régions de source et de drain des premier et deuxième transistors sont en silicium épitaxié, et les régions de source et de drain du troisième transistor sont en SiGe épitaxié.

Selon un mode de réalisation, le substrat est de type semiconducteur sur isolant.

Selon un mode de réalisation, les régions de source et de drain des premier et deuxième transistors ont une épaisseur comprise entre 10 nm et 25 nm, et les régions de source et de drain du troisième transistor ont une épaisseur comprise entre 10 nm et 25 nm.

Selon un mode de réalisation, chaque premier, deuxième et troisième transistor comprend une grille, chaque grille comprenant un empilement d'une première couche isolante et d'une couche conductrice, les grilles des premier et deuxième transistors comprenant une première couche isolante recouvrant les parois de l'empilement de la première couche isolante et de la couche conductrice et un premier espaceur recouvrant la première couche isolante, les régions de source et de drain des premier et deuxième transistors étant séparées par l'empilement de la première couche isolante et de la couche conductrice, la première couche et le premier espaceur, les grilles des troisième transistors comprenant un deuxième espaceur recouvrant les parois de l'empilement de la première couche isolante et de la couche conductrice et un troisième espaceur, les régions de source et de drain du troisième transistor étant séparées par l'empilement de la première couche isolante et de la couche conductrice, et le deuxième espaceur, le troisième espaceur reposant sur les régions de source et de drain du troisième transistor.

Selon un mode de réalisation, le deuxième espaceur et la première couche sont en le même matériau.

Selon un mode de réalisation, la formation du premier transistor et la formation du deuxième transistor comprennent la formation par épitaxie des régions de source et de drain des premier et deuxième transistors, la troisième région étant recouverte d'une deuxième couche en nitrure de silicium durant la formation par épitaxie des régions de source et de drain des premier et deuxième transistors.

Selon un mode de réalisation, le procédé comprend, après la formation des régions de source et de drain des premier et deuxième transistors, la gravure de la deuxième couche pour former le troisième espaceur.

Selon un mode de réalisation, les première et deuxième régions sont couverts d'un masque de résine lors de la formation du troisième espaceur.

Selon un mode de réalisation, la formation du troisième transistor comprend la formation par épitaxie des régions de source et de drain, les première et deuxième régions étant recouvertes d'une troisième couche en nitrure de silicium durant la formation par épitaxie des régions de source et de drain.

Selon un mode de réalisation, le procédé comprend, avant la formation des régions de source et de drain du troisième transistor, la gravure de la troisième couche dans la troisième région, de manière à former le deuxième espaceur.

Selon un mode de réalisation, le procédé comprend, entre la formation par épitaxie des régions de sources et de drain du troisième transistor et la formation par épitaxie des régions de sources et de drain des premier et deuxième transistors, la formation de la deuxième couche et la gravure des deuxième et troisième couche dans les première et deuxième régions pour former la première couche et l'espaceur.

Selon un mode de réalisation, la formation du premier transistor comprend au moins une étape de dopage comprenant la formation d'un masque de résine recouvrant les deuxième et troisième régions et une étape d'implantation de dopants, et la formation du deuxième transistor comprend au moins une étape de dopage comprenant la formation d'un masque de résine recouvrant les première et troisième régions et une étape d'implantation de dopants.

### Brève description des dessins

Ces caractéristiques et avantages, ainsi que d'autres, seront exposés en détail dans la description suivante de modes de réalisation particuliers faite à titre non limitatif en relation avec les figures jointes parmi lesquelles :
la figure 1 représente un mode de réalisation d'un dispositif électronique ; et
la figure **2****,** la figure **3****,** la figure **4****,** la figure **5****,** la figure 6, la figure 7, la figure 8, la figure 9 et la figure 10 représentent des structures résultant d'étapes d'un procédé de fabrication du dispositif de la figure **1****.**

### Description des modes de réalisation

De mêmes éléments ont été désignés par de mêmes références dans les différentes figures. En particulier, les éléments structurels et/ou fonctionnels communs aux différents modes de réalisation peuvent présenter les mêmes références et peuvent disposer de propriétés structurelles, dimensionnelles et matérielles identiques.

Par souci de clarté, seuls les étapes et éléments utiles à la compréhension des modes de réalisation décrits ont été représentés et sont détaillés.

Sauf précision contraire, lorsque l'on fait référence à deux éléments connectés entre eux, cela signifie directement connectés sans éléments intermédiaires autres que des conducteurs, et lorsque l'on fait référence à deux éléments reliés (en anglais « coupled ») entre eux, cela signifie que ces deux éléments peuvent être connectés ou être reliés par l'intermédiaire d'un ou plusieurs autres éléments.

Dans la description qui suit, lorsque l'on fait référence à des qualificatifs de position absolue, tels que les termes « avant », « arrière », « haut », « bas », « gauche », « droite », etc., ou relative, tels que les termes « dessus », « dessous », « supérieur », « inférieur », etc., ou à des qualificatifs d'orientation, tels que les termes « horizontal », « vertical », etc., il est fait référence, sauf précision contraire, à l'orientation des figures.

Sauf précision contraire, les expressions « environ », « approximativement », « sensiblement », et « de l'ordre de » signifient à 10 % ou à 10° près, de préférence à 5 % ou à 5° près.

Les modes de réalisation décrits par la suite sont par exemple destinés à l'industrie automobile.

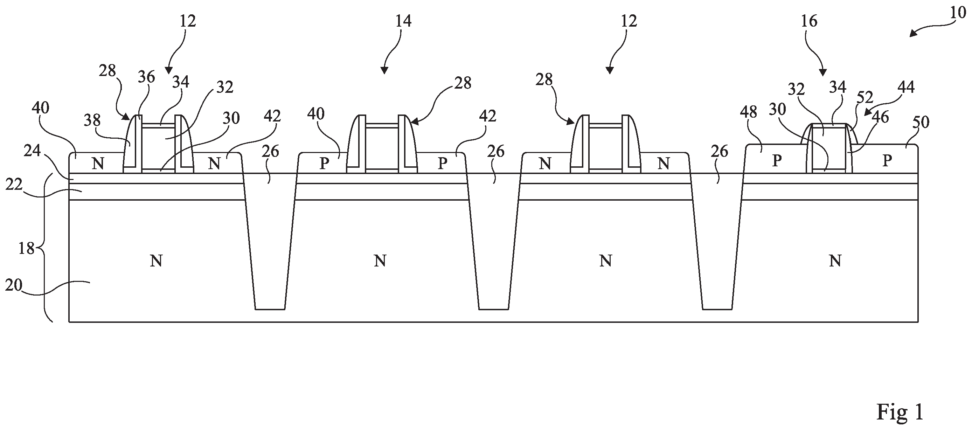

La figure 1 représente un mode de réalisation d'un dispositif électronique 10. Le dispositif 10 comprend des composants électroniques, et en particulier des transistors. Plus précisément, le dispositif 10 comprend au moins un transistor 12 d'un premier type, dont deux sont représentés, au moins un transistor 14 d'un deuxième type, un seul transistor 14 étant représenté, et au moins un transistor 16 d'un troisième type, un seul transistor 16 étant représenté. En pratique, le dispositif 10 comprend un nombre quelconque de transistors 12, 14, et 16.

Les transistors 12, 14 et 16 sont des transistors à effet de champ à structure métal-oxyde-semiconducteur (MOSFET - metal-oxide-semiconductor field-effect transistor). Les transistors 12 sont des transistors à canal N et les transistors 14 et 16 sont des transistors à canal P. Les transistors 12 et 14 sont des transistors dont les régions de source et de drain sont formées dans des régions en silicium dopé. Le transistor 16 est un transistor dont les régions de source et de drain sont formées dans des régions en SiGeB, c'est-à-dire en SiGe dopé in situ. L'utilisation de SiGeB pour les régions de source et de drain permet de diminuer la résistance d'accès et d'augmenter le stress compressif dans le canal, ce qui permet d'améliorer le déplacement des trous.

La figure 1 représente ainsi deux structures CMOS (Complementary metal-oxide-semiconductor) : une structure dite standard comprenant un des transistors 12 et le transistor 14 et une structure dite à haute performance comprenant un des transistors 12 et le transistor 16.

Les transistors 12, 14, 16 sont formés dans et sur un même substrat 18. Dans l'exemple de la figure 1, le substrat 18 est un substrat de type semiconducteur sur isolant (SOI - semiconductor on insulator). Le substrat 18 comprend ainsi un support 20 en un matériau semiconducteur, par exemple en silicium, une couche isolante 22, par exemple en oxyde de silicium, recouvrant une face supérieure du support 20, et une couche semiconductrice 24, recouvrant une face supérieure de la couche 22. La couche 24 est par exemple en SiGe sous les transistors 14 et 16 et par exemple en silicium sous les transistors 12. Le support 20 est par exemple dopé, par exemple dopé de type N.

Les transistors 12, 14, 16 sont par exemple séparés les uns des autres par des tranchées 26. Chaque transistor 12, 14, 16 est par exemple entouré par une des tranchées 26. Les tranchées 26 sont par exemple des tranchées isolantes peu profondes (STI). Les tranchées 26 sont par exemple en oxyde de silicium. Les tranchées 26 s'étendent sur toute la hauteur des couches 22 et 24 et sur une partie de la hauteur du support 20.

Le dispositif comprend par exemple des lignes de transistors 12, 14, 16 s'étendant dans une direction orthogonale au plan de la figure 1, les lignes de transistors étant séparées les unes des autres par les tranchées 26.

Les transistors 12 comprennent chacun une grille 28. La grille 28 comprend un empilement reposant sur, de préférence en contact avec, la couche 24. Ledit empilement comprend :
- une couche isolante 30, par exemple un empilement d'une couche en SiON et d'une couche en HfO2, ayant par exemple une épaisseur comprise entre 2 nm et 4 nm, constituant l'isolant de grille ;
- une couche conductrice 32, par exemple un empilement d'une couche fine en TiN, d'épaisseur par exemple sensiblement égale à 5 nm, et d'une couche en silicium polycristallin, ayant par exemple une épaisseur comprise entre 30 nm et 60 nm, constituant le conducteur de grille ; et
- une couche 34 de protection, par exemple en oxyde de silicium ayant par exemple une épaisseur comprise entre 5 nm et 20 nm, recouvrant par exemple directement la couche conductrice 32.

Les couches 30, 32, 34 de l'empilement ont de préférence des dimensions horizontales sensiblement égales. Ainsi, les parois latérales des couches 30, 32, 34 sont de préférence coplanaires, c'est-à-dire alignées.

Chaque grille 28 comprend en outre une couche isolante 36, par exemple en nitrure de silicium ou en SiBCN, s'étendant sur les parois latérales des couches 30, 32, 34 de l'empilement et sur la partie de la face supérieure de la couche 24 autour de l'empilement. Par exemple, la partie de la couche 36 s'étendant sur les parois latérales de l'empilement a par exemple une hauteur supérieure à la hauteur de l'empilement. Chaque grille 28 comprend aussi un espaceur recouvrant, de préférence uniquement, la couche 36.

Chaque transistor 12 comprend en outre une couche semiconductrice 40 et une couche semiconductrice 42. Les couches 40 et 42 sont en silicium dopé de type **N.** Les couches 40 et 42 sont situées sur, de préférence en contact avec la couche 24. Les couches 40 et 42 ont par exemple une épaisseur comprise entre 10 nm et 25 nm. Les couches 40 et 42 sont situées de part et d'autre de la grille 28. Les couches 40 et 42 sont par exemple en contact avec la couche 36 et avec l'espaceur 38. Les couches 40 et 42 sont ainsi séparées l'une de l'autre par la grille 28. Les couches 40 et 42 constituent une partie des régions de source et de drain du transistor 12. Les parties de la couche 24 situées sous les couches 40 et 42 constituent l'autre partie des régions de source et de drain. Ainsi, la région de source et la région de drain sont chacune constituée d'une couche 40 ou 42 et de la partie de la couche 24 située sous cette couche 40 ou 42.

Les transistors 14 comprennent les éléments des transistors 12. Ainsi, chaque transistor 14 comprend les régions 40 et 42 et la grille 28, c'est-à-dire l'empilement des couches 30, 32, 34, la couche 36 et l'espaceur 38. Les transistors 14 diffèrent des transistors 12 en ce que les couches 40 et 42 des transistors 14 sont dopées de type P et non de type N.

Les transistors 16 comprennent une grille 44. La grille 44 comprend l'empilement présent dans les grilles 28. Ainsi, la grille 44 comprend l'empilement des couches 30, 32, 34. La grille 44 comprend en outre un espaceurs 46, s'étendant sur les parois latérales de l'empilement. L'espaceur 46 s'étend de préférence sur toute la hauteur des parois latérales de l'empilement. L'espaceur 46 est par exemple en nitrure de silicium.

Chaque transistor 16 comprend en outre une couche semiconductrice 48 et une couche semiconductrice 50. Les couches 48 et 50 sont en SiGeB. Les couches 48 et 50 sont situées sur, de préférence en contact avec la couche 24. Les couches 48 et 50 sont situées de part et d'autre de la grille 44. Les couches 48 et 50 ont par exemple une épaisseur comprise entre 10 nm et 25 nm. Les couches 48 et 50 sont par exemple en contact avec l'espaceur 46. La distance maximale entre la région 48 ou la région 50 et l'empilement des couches 30, 32, 34, c'est-à-dire la largeur maximale de l'espaceur 46, autrement dit la largeur de la portion de la face supérieure de la couche 24 recouverte par l'espaceur 46, est par exemple comprise entre 4 nm et 12 nm. Les couches 48 et 50 sont ainsi séparées l'une de l'autre par la grille 44. Les couches 48 et 50 constituent les régions de source et de drain du transistor 16. Les parties de la couche 24 situées sous les couches 48 et 50 constituent l'autre partie des régions de source et de drain. Ainsi, la région de source et la région de drain sont chacune constituée d'une couche 48 et 50 et de la partie de la couche 24 située sous cette couche 48 et 50.

Chaque transistor 16 comprend aussi un espaceurs 52. L'espaceur 52 est par exemple en nitrure de silicium. L'espaceur 52 recouvre une partie supérieure de l'espaceur 46 et une partie de la face supérieure des couches 48 et 50.

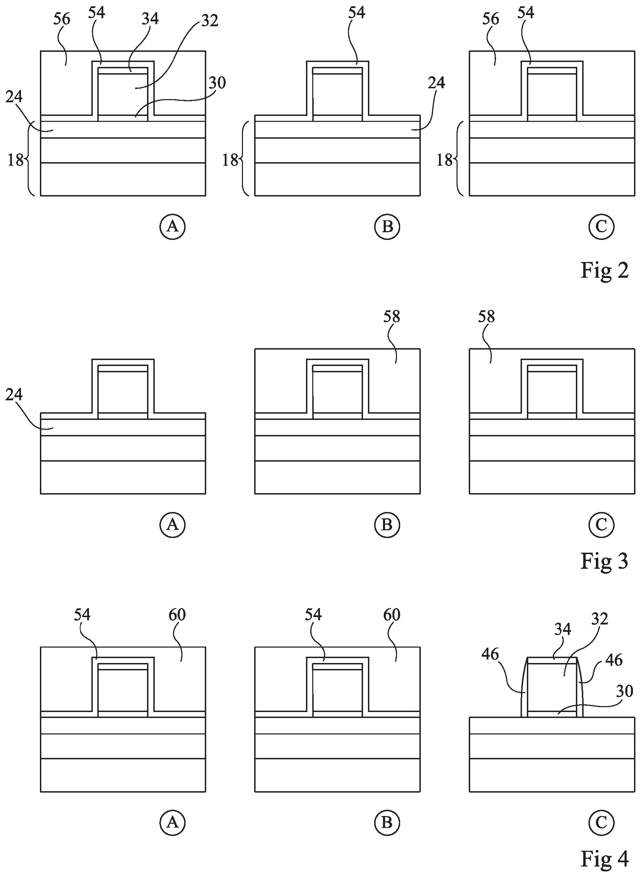

Les figures 2 à 10 représentent des structures résultant d'étapes, de préférence successives, d'un procédé de fabrication du dispositif de la figure 1. Plus précisément, chaque figure 2 à 10 comprend trois vues A, B et C correspondant à des régions différentes d'un même dispositif dans lesquelles sont respectivement formés un transistor 12, un transistor 14 et un transistor 16. Les étapes du procédé sont, sauf précision contraire, effectuées simultanément dans les régions des vues A, B et C.

La figure 2 représente une structure résultant d'une étape du procédé de fabrication du dispositif de la figure 1.

Au cours de l'étape résultant en la structure de la figure 2, l'empilement des couches 30, 32, 34 de chaque transistor 12, 14, 16 est formé sur le substrat SOI 18. La formation de l'empilement comprend par exemple la formation des couches 30, 32 et 34 sur toute la face supérieure de la couche 24 et la gravure des couches 30, 32, 34 de manière à conserver les empilements aux emplacements des transistors 12, 14 et 16. La couche 34 correspond par exemple au masque dur utilisé pour former l'empilement des couches 30, 32, 34 de chaque transistor 12, 14, 16.

L'étape de la figure 2 comprend en outre la formation d'une couche isolante 54. La couche 54 est en le matériau de la couche 36, par exemple en nitrure de silicium ou en SiBCN. La couche 54 est de préférence formée sur l'ensemble de la structure. La couche 54 recouvre ainsi les empilements de couches 30, 32, 34 et la face supérieure de la couche 24 au moins dans les régions des vues A, B et C.

L'étape de la figure 2 comprend, de plus, la formation d'un masque de protection 56, par exemple en résine. Le masque 56 recouvre entièrement au moins les régions des vues A et C, et ne recouvre pas la région de la vue B. De préférence, le masque 56 recouvre entièrement la structure à l'exception des régions de la vue B, c'est-à-dire les emplacements de formation des transistors 14.

L'étape de la figure 2 comprend en outre une étape de dopage dite LDD (Lightly Doped Drain - drain faiblement dopé). Au cours de cette étape, la couche 24 est ainsi dopée dans la région de la vue B, de manière à doper, de type P, les parties de la couche 24 faisant partie du drain et de la source.

La figure 3 représente une structure résultant d'une étape du procédé de fabrication du dispositif de la figure 1.

L'étape de la figure 3 comprend le retrait, par exemple la gravure, du masque 56.

L'étape de la figure 3 comprend, de plus, la formation d'un masque de protection 58, par exemple en résine. Le masque 58 recouvre entièrement au moins les régions des vues B et C, et ne recouvre pas la région de la vue A. De préférence, le masque 58 recouvre entièrement la structure à l'exception des régions de la vue A, c'est-à-dire les emplacements de formation des transistors 12.

L'étape de la figure 3 comprend en outre une étape de dopage dite LDD (Lightly Doped Drain - drain faiblement dopé). Au cours de cette étape, la couche 24 est ainsi dopée dans la région de la vue A, de manière à doper, de type N, les parties de la couche 24 faisant partie du drain et de la source.

La figure 4 représente une structure résultant d'une étape du procédé de fabrication du dispositif de la figure 1.

L'étape de la figure 4 comprend le retrait, par exemple la gravure, du masque 58.

L'étape de la figure 4 comprend, de plus, la formation d'un masque de protection 60, par exemple en résine. Le masque 60 recouvre entièrement au moins les régions des vues A et B, et ne recouvre pas la région de la vue C. De préférence, le masque 60 recouvre entièrement la structure à l'exception des régions de la vue C, c'est-à-dire les emplacements de formation des transistors 16.

L'étape de la figure 4 comprend en outre la formation des espaceurs 46 dans les régions de formation des transistors 16, c'est-à-dire les régions de la vue C. La formation des espaceurs comprend par exemple une étape de gravure anisotrope de la couche 54 dans les régions correspondant à la vue C. Les portions de la couche 54 situées dans les régions correspondant aux vues A et B sont protégées par le masque 60.

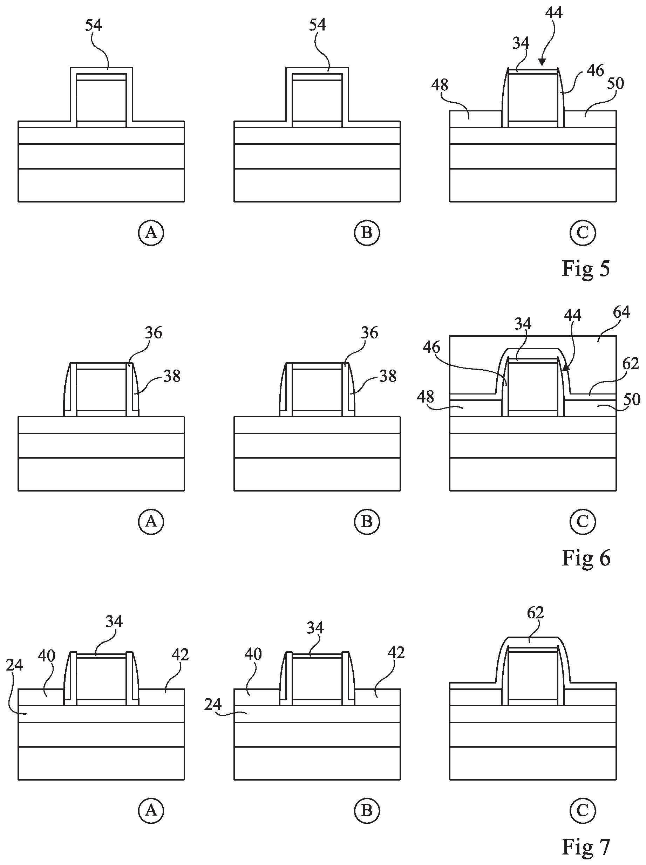

La figure 5 représente une structure résultant d'une étape du procédé de fabrication du dispositif de la figure 1.

L'étape de la figure 5 comprend le retrait du masque 60.

L'étape de la figure 5 comprend une étape de nettoyage avant croissance épitaxiale. Au cours de cette étape de nettoyage, une partie de l'épaisseur de la couche 34 dans les régions correspondant à la vue C est retirée.

L'étape de la figure 5 comprend en outre la formation des couches 48 et 50. Plus précisément, l'étape de la figure 5 comprend une étape de croissance épitaxiale de SiGeB à partir de la couche 24 dans les régions correspondant à la vue C. Des couches de SiGeB sont ainsi formées de part et d'autre de la grille 44, par exemple sur une épaisseur comprise entre 10 nm et 30 nm. La croissance épitaxiale du SiGeB est bloquée dans les régions correspondant aux vues A et B par la couche 54.

La figure 6 représente une structure résultant d'une étape du procédé de fabrication du dispositif de la figure 1.

Au cours de l'étape de la figure 6, une couche 62 en le matériau des espaceurs 38 est formée sur l'ensemble de la structure. Ainsi, dans les régions correspondant aux vues A et B, la couche 62 recouvre la couche 54 et dans les régions correspondant à la vue C, la couche 62 recouvre les couches 48 et 50, les espaceurs 46 et la couche 34.

L'étape de la figure 6 comprend ensuite, la formation d'un masque de protection 64, par exemple en résine, recouvrant au moins les régions correspondant à la vue C. Le masque 64 ne recouvre pas les régions correspondant aux vues A et B.

L'étape de la figure 6 comprend en outre la formation des espaceurs 38 et des couches 36 des grilles 28. Plus précisément, l'étape de la figure 6 comprend par exemple une étape de gravure anisotrope des couches 54 et 62 dans les régions correspondant aux vues A et B. Les portions de la couche 62 situées dans les régions correspondant à la vue C sont protégées par le masque 64.

La figure 7 représente une structure résultant d'une étape du procédé de fabrication du dispositif de la figure 1.

L'étape de la figure 7 comprend une étape de nettoyage avant croissance épitaxiale. Au cours de cette étape de nettoyage, une partie de l'épaisseur de la couche 34 dans les régions correspondant aux vues A et B est retirée.

L'étape de la figure 7 comprend en outre la formation des couches 40 et 42. Plus précisément, l'étape de la figure 7 comprend une étape de croissance épitaxiale de silicium à partir de la couche 24 dans les régions correspondant aux vues A et B. Des couches de silicium sont ainsi formées de part et d'autre de chaque grille 28. La croissance épitaxiale du silicium est bloquée dans les régions correspondant à la vue C par la couche 62.

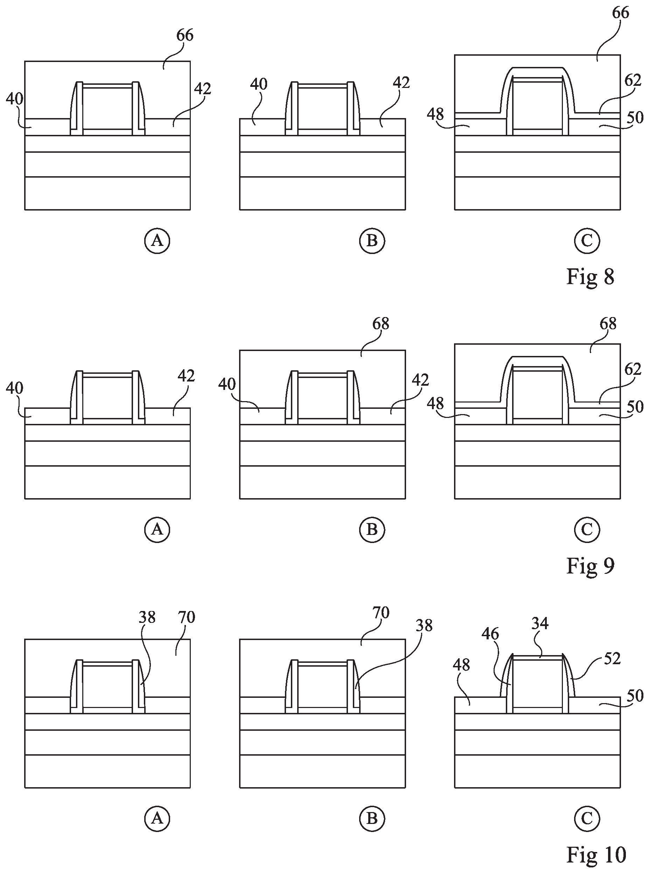

La figure 8 représente une structure résultant d'une étape du procédé de fabrication du dispositif de la figure 1.

L'étape de la figure 8 comprend la formation d'un masque de protection 66, par exemple en résine. Le masque 66 recouvre entièrement au moins les régions des vues A et C, et ne recouvre pas la région de la vue B. De préférence, le masque 66 recouvre entièrement la structure à l'exception des régions de la vue B, c'est-à-dire les emplacements de formation des transistors 14.

L'étape de la figure 8 comprend en outre une étape de dopage de type P, par exemple d'implantation d'atomes de bore. Au cours de cette étape, les couches 40 et 42 sont ainsi dopées dans la région de la vue B, de manière à former les régions de drain et de source.

Les couches 40 et 42 des régions correspondant à la vue A et les couches 48 et 50 des régions correspondant à la vue C sont protégées durant le dopage par le masque 66.

La figure 9 représente une structure résultant d'une étape du procédé de fabrication du dispositif de la figure 1.

L'étape de la figure 9 comprend le retrait, par exemple la gravure, du masque 66.

L'étape de la figure 9 comprend la formation d'un masque de protection 68, par exemple en résine. Le masque 68 recouvre entièrement au moins les régions des vues B et C, et ne recouvre pas la région de la vue A. De préférence, le masque 68 recouvre entièrement la structure à l'exception des régions de la vue A, c'est-à-dire les emplacements de formation des transistors 12.

L'étape de la figure 9 comprend en outre une étape de dopage de type N, par exemple d'implantation d'atomes d'arsenic ou de phosphore. Au cours de cette étape, les couches 40 et 42 sont ainsi dopées dans la région de la vue A, de manière à former les régions de drain et de source.

Les couches 40 et 42 des régions correspondant à la vue B et les couches 48 et 50 des régions correspondant à la vue C sont protégées durant le dopage par le masque 68.

La figure 10 représente une structure résultant d'une étape du procédé de fabrication du dispositif de la figure 1.

L'étape de la figure 10 comprend le retrait, par exemple la gravure, du masque 68.

L'étape de la figure 10 comprend la formation d'un masque dur 70, par exemple en résine. Le masque 70 recouvre entièrement au moins les régions des vues A et B, et ne recouvre pas la région de la vue C. De préférence, le masque 70 recouvre entièrement la structure à l'exception des régions de la vue C, c'est-à-dire les emplacements de formation des transistors 16.

L'étape de la figure 10 comprend en outre la formation des espaceurs 52. Plus précisément, l'étape de la figure 10 comprend par exemple une étape de gravure anisotrope de la couche 62 dans les régions correspondant à la vue C.

L'étape de la figure 10 comprend en outre le retrait, par exemple par gravure, de la couche 62 dans la région de la vue C.

Le procédé peut comprendre, par la suite, une étape de retrait du masque 70 et une étape de siliciuration. Alternativement, le procédé peut ne pas comprendre le retrait du masque 70.

Selon une variante du procédé des figures 2 à 10, l'étape de la figure 10 peut être modifiée de manière à ne pas comprendre la formation du masque 70. L'étape de formation des espaceurs 46 peut alors entrainer une gravure partielle des espaceurs 38. De manière à minimiser la durée de cette gravure partielle, la couche 62 a par exemple une épaisseur inférieure à 15 nm. Cette variante a pour avantage de retirer la formation d'un masque de gravure.

Le procédé comprend en outre la formation des tranchées 26. Cette étape peut être effectuée avant la formation des transistors 12, 14, 16.

Un avantage des modes de réalisation décrits est qu'ils permettent de former un dispositif comprenant, sur un même substrat, des transistors à canal P et à canal N dont les zones de drain et de source sont en silicium et des transistors à canal P haute performance dont les zones de drain et de source sont en SiGeB.

Divers modes de réalisation et variantes ont été décrits. La personne du métier comprendra que certaines caractéristiques de ces divers modes de réalisation et variantes pourraient être combinées, et d'autres variantes apparaîtront à la personne du métier.

Enfin, la mise en œuvre pratique des modes de réalisation et variantes décrits est à la portée de la personne du métier à partir des indications fonctionnelles données ci-dessus.

## Revendications

1. Dispositif électronique (10) comprenant, sur un même substrat (18) :
- un premier transistor (12) à canal N, situé dans une première région (A) du substrat (18) ;
- un deuxième transistor (14) à canal P, situé dans une deuxième région (B) du substrat (18) ; et
- un troisième transistor (16) à canal P, situé dans une troisième région (C) du substrat (18),
des régions (40, 42) de source et de drain des premier et deuxième transistors (12, 14) sont en silicium épitaxié, et des régions (48, 50) de source et de drain du troisième transistor (16) sont en SiGe épitaxié.

2. Procédé de formation d'un dispositif électronique (10) comprenant, sur un même substrat (18) :
a) la formation d'un premier transistor (12) à canal N, situé dans une première région (A) du substrat (18) ;
b) la formation d'un deuxième transistor (14) à canal P, situé dans une deuxième région (B) du substrat (18) ; et
c) la formation d'un troisième transistor (16) à canal P, situé dans une troisième région (C) du substrat (18),
les régions (40, 42) de source et de drain des premier et deuxième transistors (12, 14) sont en silicium épitaxié, et les régions (48, 50) de source et de drain du troisième transistor (16) sont en SiGe épitaxié.

3. Dispositif selon la revendication 1 ou procédé selon la revendication 2, dans lequel le substrat (18) est de type semiconducteur sur isolant.

4. Dispositif selon la revendication 1 ou 3 ou procédé selon la revendication 2 ou 3, dans lequel les régions (40, 42) de source et de drain des premier et deuxième transistors (12, 14) ont une épaisseur comprise entre 10 nm et 25 nm, et les régions (48, 50) de source et de drain du troisième transistor (16) ont une épaisseur comprise entre 10 nm et 25 nm.

5. Dispositif selon l'une quelconque des revendications 1, 3 ou 4 ou procédé selon l'une quelconque des revendications 2 à 4, dans lequel chaque premier (12), deuxième (14) et troisième (16) transistor comprend une grille (28, 44), chaque grille (28, 44) comprenant un empilement d'une première couche isolante (30) et d'une couche conductrice (32), les grilles (28) des premier (12) et deuxième (14) transistors comprenant une première couche isolante (36) recouvrant les parois de l'empilement de la première couche isolante (30) et de la couche conductrice (32) et un premier espaceur (38) recouvrant la première couche isolante (36), les régions (40, 42) de source et de drain des premier (12) et deuxième (14) transistors étant séparées par l'empilement de la première couche isolante (30) et de la couche conductrice (32), la première couche (36) et le premier espaceur (38), les grilles (44) des troisième transistors (16) comprenant un deuxième espaceur (46) recouvrant les parois de l'empilement de la première couche isolante (30) et de la couche conductrice (32) et un troisième espaceur (52), les régions de source et de drain (48, 50) du troisième transistor (16) étant séparées par l'empilement de la première couche isolante (30) et de la couche conductrice (32), et le deuxième espaceur (46), le troisième espaceur (52) reposant sur les régions de source et de drain (48, 50) du troisième transistor (16).

6. Dispositif ou procédé selon la revendication 5, dans lequel le deuxième espaceur (46) et la première couche (36) sont en le même matériau.

7. Dispositif ou procédé selon la revendication 5 ou 6, dans lequel la couche conductrice (32) est recouverte d'une couche de protection (34) en oxyde de silicium.

8. Procédé selon l'une quelconque des revendications 2 à 7, dans lequel la formation du premier transistor (12) et la formation du deuxième transistor (14) comprennent la formation par épitaxie des régions de source et de drain (40, 42) des premier (12) et deuxième (14) transistors, la troisième région (C) étant recouverte d'une deuxième couche (62) en nitrure de silicium durant la formation par épitaxie des régions de source et de drain (40, 42) des premier (12) et deuxième (14) transistors.

9. Procédé selon l'une quelconque des revendications 5 à 7 et la revendication 8, dans lequel le procédé comprend, après la formation des régions de source et de drain (40, 42) des premier (12) et deuxième (14) transistors, la gravure de la deuxième couche (62) pour former le troisième espaceur (52).

10. Procédé selon la revendication 8 ou 9, dans lequel les première et deuxième régions (A, B) sont couverts d'un masque de résine lors de la formation du troisième espaceur (52).

11. Procédé selon l'une quelconque des revendications 2 à 10, dans lequel la formation du troisième transistor (16) comprend la formation par épitaxie des régions de source et de drain (48, 50), les première (A) et deuxième (B) régions étant recouvertes d'une troisième couche (54) en nitrure de silicium durant la formation par épitaxie des régions de source et de drain (48, 50).

12. Procédé selon l'une quelconque des revendications 6 à 10, la revendication 8 et la revendication 11, dans lequel le procédé comprend, avant la formation des régions de source et de drain (48, 50) du troisième transistors (16), la gravure de la troisième couche (54) dans la troisième région (C), de manière à former le deuxième espaceur (46).

13. Procédé selon l'une quelconque des revendications 5 à 7, la revendication 8 ou 9 et la revendication 11 ou 12, dans lequel le procédé comprend, entre la formation par épitaxie des régions de sources et de drain (48, 50) du troisième transistor (16) et la formation par épitaxie des régions de sources et de drain (40, 42) des premier et deuxième transistors (12, 14), la formation de la deuxième couche (62) et la gravure des deuxième (62) et troisième (54) couche dans les première et deuxième régions (A, B) pour former la première couche (36) et l'espaceur (38).

14. Procédé selon l'une quelconque des revendications 2 à 13, dans lequel la formation du premier transistor (12) comprend au moins une étape de dopage comprenant la formation d'un masque de résine recouvrant les deuxième et troisième régions (B, C) et une étape d'implantation de dopants, et dans lequel la formation du deuxième transistor (14) comprend au moins une étape de dopage comprenant la formation d'un masque de résine recouvrant les première et troisième régions (A, C) et une étape d'implantation de dopants.
